# EUROPEAN PATENT SPECIFICATION

(11) **EP 2 169 705 B1**
(45) Date of publication and mention of the grant of the patent: **24.08.2011**
(21) Application number: 09011677.3
(22) Date of filing: 11.09.2009
(51) Int. Cl.: H01K 1/28, H01K 1/16, H01K 1/24, H01K 9/08

(54) **Filament lamp**
Glühlampe
Lampe à incandescence

(30) Priority: 26.09.2008 JP 2008247069
(43) Date of publication of application: 31.03.2010
(73) Proprietor: USHIODENKI KABUSHIKI KAISHA, Chiyoda-ku 100 Tokyo (JP)
(72) Inventor: Tanino, Kenji, Himeji-shi Hyogo-ken (JP); Mizukawa, Yoichi, Himeji-shi Hyogo-ken (JP)
(74) Representative: Tomerius, Isabel

(56) References cited:
- EP-A1- 1 344 753
- EP-A2- 1 998 358
- US-A- 5 686 794
- US-A1- 2002 024 277
- US-A1- 2006 197 454
- US-A1- 2008 050 104

## Description

### Background of the Invention

### Field of Invention

The present invention relates to a filament lamp, particularly to a filament lamp for heating an object to be treated.

### Description of Related Art

The production steps for solar cells include a thermal diffusion step for diffusing a P type semiconductor and a baking step for baking silver paste to make electrode material. In both steps, a semiconductor wafer and a glass substrate are heated to a high temperature of around 800 °C to 900 °C using a thermal diffusion furnace and a baking furnace, respectively.

In such a heating device, an object to be treated must be heated uniformly in order to avoid a locational variation of temperature. For this reason, what has been proposed is a structure capable of providing multiple power supply pathways inside the luminous tube of a filament lamp as a light source and independently supplying a desired amount of electricity to each pathway (Japanese Laid-open Application No. 2006-279008 and corresponding U.S. Patent Application Publication 2006/0197454). However, the temperature to which an object to be treated is heated in the production steps noted above has been increasing, and the amount of electricity to be supplied to a lamp has also been increasing. On the other hand, the size of a lamp cannot be increased, and there is a demand for reducing the size thereof instead.

Each filament is connected with an internal lead for supplying electricity, and internal leads form complicated pathways inside a luminous tube. For this reason, there occurs a problem that an internal lead and a filament or two internal leads electrically short to each other or that a filament comes off a specified position. In other words, in a filament lamp having a plurality of independent power supply pathways, the lamp has an extremely complicated structure so that an object to be treated can be heated uniformly. As a result, the above mentioned problems occur.

Document US 2008/0050104 A1 discloses a filament lamp having multiple filaments which can be power supplied individually. It aims to prevent the occurrence of unwanted discharge between adjacent portions of neighboring filaments. In order to solve this problem, it is taught to reduce the electrical potential between such neighboring parts within the filament lamp, between which an unwanted discharge might occur. With alternating current power supplied to each filament independently, the current is supplied with the same phase and mutually adjacent terminals of neighboring filament assemblies will have the same potential. In the case that direct current power is supplied to each filament independently, adjacent terminals of neighboring filament assemblies will be of the same polarity.

Document EP 1 998 358 A2 is an intermediate document and discloses a filament lamp and light-irradiation-type heat treatment device. In order to assure insulation between a filament and the respective leads surrounding the filament as well as between leads in the vicinity of the filaments, it is disclosed to provide inner tubes between the filaments and leads. The inner tubes are provided with several lead accommodation spaces through which the leads are passed.

### Summary of the Invention

A primary object of the present invention is to provide a filament lamp having a plurality of independent power supply pathways in which the various problems, such as the positional deviation of a filament and short-circuiting, are efficiently prevented despite the presence of the complicated power supply pathways.

The object is solved with the filament lamp according to claim 1. Preferred embodiments are claimed in the dependent claims.

The filament lamp according to the present invention comprises a straight-tube type luminous part having multiple filaments divided in the axial direction, and sealing parts on opposite ends of the luminous part in which metal foils corresponding to the number of filaments are disposed in an aligned manner, wherein the structure is such that electricity can independently be supplied to each filament with respective leads, wherein the luminous part comprises a first housing space for housing the filaments and a second housing space for housing internal leads for supplying electricity, and wherein the housing spaces are paired and extend in the axial direction. Partitions are formed between the first housing space and the second housing space.

Furthermore, the present invention is also characterized in that the cross section of the luminous part is substantially gourd-shaped.

Furthermore, the present invention is also characterized in that the filaments are held in the first housing space with ring-shaped supporters.

This invention provides a structure in which the first housing space for housing the filaments and the second housing space for housing the internal leads for supplying electricity are paired and extend in the axial direction. Therefore, the problem that an internal lead and a filament or another lead electrically short to each other can be solved or reduced. Moreover, since the filaments can be held in the first housing space in which there exists no internal lead, the filaments can be positioned accurately.

### Brief Description of Drawings

Fig. 1 shows the entire configuration of the filament lamp according to the present invention.

Fig. 2 shows the cross-sectional shape of the luminous part in the filament lamp according to the present invention.

Figs. 3(b) - 3(c) show other examples of the cross-sectional shape of the luminous part in the filament lamp according to the present invention. Fig. 3(a) shows a comparative example not belonging to the invention.

Fig. 4 shows another embodiment of the filament lamp according to the present invention.

Fig. 5 shows another embodiment of the filament lamp according to the present invention.

Fig. 6 shows a treatment device using the filament lamp according to the present invention.

### Detailed Description of the Invention

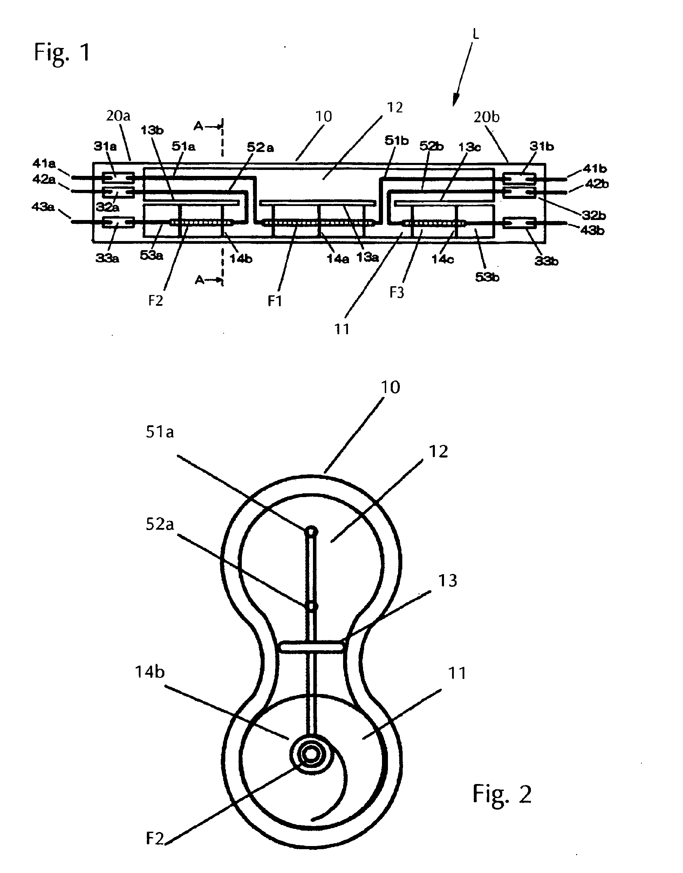

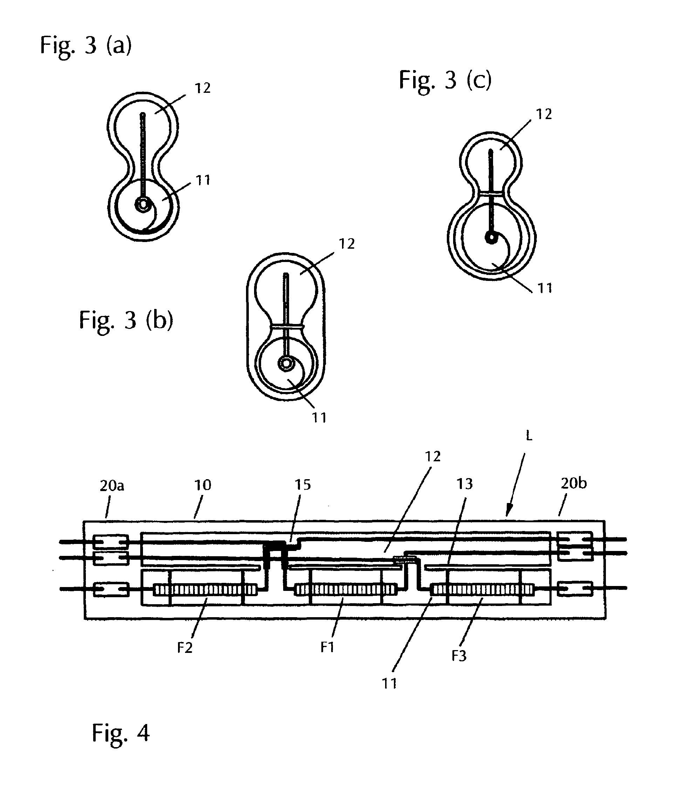

Fig. 1 shows the entire configuration of the filament lamp L according to the present invention which is comprised of a straight-tube type luminous part 10 and sealing parts 20a, 20b formed on opposite ends of luminous part 10. The luminous part 10 is formed of a first housing space 11 and a second housing space 12 as described below, and its cross section is substantially gourd-shaped as a whole (by which is meant that it is formed of sections that are at least internally circular that contain the first and second housing spaces 11, 12 and are connected to each other by a narrower neck portion, the circular sections not necessarily being of the same size; cf. Fig. 3(c)).

The first housing space 11 and the second housing space 12 are spatially linked with each other. Both spaces are paired and extend in the axial direction. Inside the first housing space 11 are disposed multiple filaments F1, F2, F3. Specifically, the filament F 1 is disposed at the center in the longitudinal direction, the filament F2 on one end of the first housing space 11 (i.e., the end portion proximate to sealing part 20a), and filament F3 on the other end of the first housing space 11 (i.e., the end portion proximate to sealing part 20b). The filament F1, the filament F2 and the filament F3 are electrically separated from each other and aligned substantially on the central axis of the first housing space 11. Each of the filament F1, the filament F2 and the filament F3 is disposed in an independent power supply pathway.

Embedded in the sealing parts 20a, 20b are meal foils 31a, 32a, 33a, 31 b, 32b 33b, corresponding to the number of the filaments F. Specifically, in the sealing part 20a are embedded the metal foil 31a for the filament F1, and the metal foils 32a, 33a for filament F2. In the sealing part 20b are embedded the metal foil 31 b for filament F1, and metal foils 32b, 33b for filament F3.

The metal foils 30 are connected with external leads 41a, 42a, 43a, 41b, 42b, 43b that extend out of the lamp and internal leads 51a, 52a, 53a, 51b, 52b, 53b for supplying electricity and extend toward the inside of the luminous part 10. Specifically, the metal foil 31a is connected with the external lead 41 a and the internal lead 51a, the metal foil 32a with the external lead 42a and the internal lead 52a, and the metal foil 33a with the external lead 43a and the internal lead 53a. Also, the metal foil 31b is connected with the external lead 41 b and the internal lead 51 b, the metal foil 32b with the external lead 42b and the internal lead 52b, and the metal foil 33b with the external lead 43b and the internal lead 53b.

The internal leads 51a, 51b, 52a, 52b are disposed in the second housing space 12. The internal leads 53a, 53b are disposed in the first housing space 11 in terms of the positional relationship with respect to the metal foils.

Partitions 13a, 13b, 13c are formed between the first housing space 11 and the second housing space 12. Specifically, the partition 13b is formed in order to spatially isolate the internal leads 51a, 52a from the filament F2. The partition 13c is formed in order to spatially isolate the internal leads 51b, 52b from the filament F3. The partition 13a corresponds to the filament F1 and extends along the filament F1 in the first housing space 11. The partitions 13a, 13b, 13c are made of the same material as used for the luminous part and are formed as parts of a single flat plate with holes through which the internal leads 51a, 52a and leads 51b, 52b, respectively, are routed. The partitions 13a, 13c are integrally welded together with the sealing parts 20a, 20b.

Each filament F1, F2, F3 is attached to respective ring-shaped supporters 14a, 14b, 14c. Each filament F is supported with multiple supporters 14 and positioned so that the filament F is substantially aligned with the central axis of the first housing space 11. Specifically, the filament F1 is supported with a pair of supporters 14a, the filament F2 with a pair of supporters 14b and the filament F3 with a pair of supporters 14c. Each supporter 14 is a spring-line member made, for example, of tungsten. Since it is ring-shaped, the supporter can be fixed on the inner wall of the first housing space 11 by force of elasticity. The supporters 14 are present only inside the first housing space 11, but not in the second housing space. The accuracy of positioning a filament can be enhanced by fixing a supporter inside a narrow space. Moreover, such problems as a short circuit can be prevented because the supporter does not come into contact with the internal lead 50.

Here, an independent electric power supply pathway is formed with the external lead 41a, the metal foil 31a, the internal lead 51a, the filament F1, the internal lead 51b, the metal foil 31b and the external lead 41 b. The filament F1 emits light by applying a prescribed voltage to the external lead 41a and the external lead 41b. The filament F1 is disposed in the first housing space 11 while the internal lead 51 a and the internal lead 51b are disposed in the second housing space 12.

Similarly, an independent electric power supply pathway is formed with the external lead 42a, the metal foil 32a, the internal lead 52a, the filament F2, the internal lead 53a, the metal foil 33a and the external lead 43a. The filament F2 emits light by applying a prescribed voltage to the external lead 42a and the external lead 43a. The filament F2 is disposed in the first housing space 11 while the internal lead 52a is disposed in the second housing space 12.

Moreover, an independent electric power supply pathway is formed with the external lead 42b, the metal foil 32b, the internal lead 52b, the filament F3, the internal lead 53b, the metal foil 33b and the external lead 43b. The filament F3 emits light by applying a prescribed voltage to the external lead 42b and the external lead 43b. The filament F3 is disposed in the first housing space 11 while the internal lead 52b is disposed in the second housing space 12.

The internal lead 50 may be provided with an insulating tube (not shown). The insulating tube is a pipe made of quartz glass, for example. It is effective if an insulating tube is provided at a place where another internal lead comes close.

In principle, the filaments F are housed in the first housing space 11 and the internal leads 50 in the second housing space 12 in the present invention. Nevertheless, the internal leads 53a, 53b for the filaments F2, F3, which are disposed on the end parts of the luminous part 10, may be housed in the first housing space for convenience sake. As far as the other internal leads 50 are concerned, the portions connected with the filaments F are partially disposed in the first housing space 11 while the portions extending in the longitudinal direction of the luminous part 10 are disposed in the second housing space 12.

As an example of the use of the filament lamp, an electric power of 3 kW is supplied to the filament F1 disposed at the center and an electric power of 600 kW to the filament F2 and filament F3 disposed on the end parts. The filament F1, the filament F2 and the filament F3 may be turned on at the same time, or one filament may be turned on and the other filaments turned off.

The filaments F1, F2, F3 are coil-shaped and formed by tightly winding a single tungsten wire. The luminous part 10 is sealed with an inert gas such as argon (Ar) and nitrogen (N₂) together with a halogen, such as bromide (Br) or chlorine (Cl). As for the other aspects of the filament lamp relating to the present invention, please refer to Japanese Patent Application No. 2008-82458, a previous application of the assignee of the present application, and corresponding US patent application serial No. 12/402,853 .

Fig. 2 shows a cross-sectional structure of the luminous part 10. Specifically, Fig. 2 shows the cross-sectional structure taken along line A-A in Fig. 1.

The cross section of the luminous part 10 as a whole is gourd-shaped as defined above. The first housing space 11 and the second housing space 12 are separated by partitions 13a, 13b, 13c. The gourd-shape of the luminous part 10 prevents or reduces the heating of the internal lead 50 caused by the radiant heat from the filaments F. In other words, if the internal leads are heated, some secondary radiation occurs and then an object to be heated is so disturbed that any uniform heating may be difficult. A protecting tube may be provided for the internal lead 50 in order to block radiation. However, there occurs a problem that cracks may occur arising out of an increased temperature of the protecting tube.

Figs. 3(b)-3(c) show other embodiments of the cross-sectional shape of the luminous part 10, belonging to the invention. Fig. 3(b) shows the luminous part 10 in which the external shape thereof is an oval, yet the cross section of the luminous space is substantially gourd-shaped internally. Fig. 3(c) shows an example in which the size of the first housing space 11 is different from that of the second housing space 12. Fig. 3(a) shows another illustrative example of a cross-sectional shape of the luminous part 10, not belonging to the invention. Fig. 3(a) shows a shape having no partition 13.

In Fig. 3(b), the external shape of a luminous part need not be gourd-shaped if the cross section of the inner space of the luminous part is substantially gourd-shaped. The advantage of this structure is that the strength is increased by the increased thickness of the luminous part 10 in the area of the narrow connecting portion.

In Fig. 3(c), the first space 11 is enlarged for when a large filament is required emitting light with high power. Although, it is shown in the drawing that the first housing space 11 is larger than the second housing space 12, the second housing space 12 may be larger than the first housing space 11. The advantage is that the size can be reduced in the vertical direction when the first housing space 11 is larger and that an increased number of circuits can be managed well when the second housing space 12 is larger.

Fig 4 shows another embodiment of the filament lamp according to the present invention. In the filament lamp as shown in Fig. 1, both of the external leads for the filament disposed in the vicinity of a sealing part protrude from the neighboring sealing part. On the other hand, the structure according to the present embodiment is such that all the filaments are provided with one external lead that protrudes from one sealing part and a second external lead that protrudes from the other sealing part. Specifically, while both of the external leads 42a, 43a of the filament F2 disposed in the vicinity of sealing part 20a protrude from the sealing part 20a in Fig. 1, each of the three metal foils embedded in the sealing part 20a is for a respective one of the filaments F1, F2, F3, and each of three metal foils embedded in the sealing part 20b is also for a respective one of the filaments F1, F2, F3 in Fig. 4. Accordingly, the structure is such that one terminal of each filament F protrudes from the sealing part 20a and the other terminal from the sealing part 20b. This is true for all the filaments F. In the filament lamp having such a structure, all the filaments F are housed in the first housing space 11 and the internal leads 50 in the second housing space 12 as well.

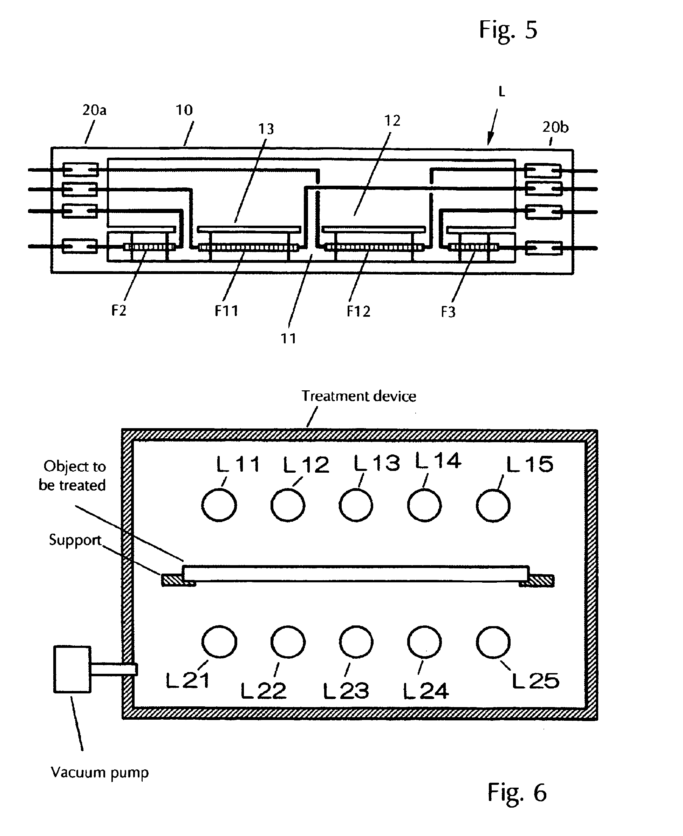

Fig. 5 shows another embodiment of the filament lamp according to the present invention. The filament as shown in Fig. 5 is different from the filament lamps as shown in Figs. 1 & 4 in that the lamp of Fig. 5 has four filaments that can independently be supplied with electric power while that of Figs. 1 & 4 has three filaments. At the center of a luminous part 10 are disposed a filament F11 and a filament F12. On one end of the luminous part 10 (i.e., the end portion close to the sealing part 20a) is disposed a filament F3. On the other end (i.e., the end portion close to the sealing part 20b) is disposed a filament F2. The filament F11, the filament F12, the filament F2 and the filament F3 are disposed in parallel with the central axis of the luminous part 10. In the filament lamp having such a structure, all the filaments F are housed in the first housing space 11 and the internal leads 50 in the second housing space 12 in principle as well. As for the structure of a lamp having four filaments, please refer to Fig. 4 in Japanese Patent Application No. 2008-82458 and corresponding US patent application serial No. 12/402,853, previous applications by the present applicant, as well.

Next, a description of a method for manufacturing the luminous tube (i.e., a glass tube before sealing) of the filament lamp according to the present invention is given below.

First, melt quartz powder at a high temperature and make an ingot having a shape similar to one desired to be produced using a metallic mold. Tube-draw the ingot to a shape desired to be produced (i.e., a gourd shape). If the desired shape to be produced is complicated, an ingot may be shaped by cutting and then tube-drawn in the same manner. After the tube drawing, a partition is formed between the first housing space and the second housing space. Alternatively, quartz powder may directly be tube-drawn at the same time that it is melted.

Insert a mount formed by connecting filaments, internal leads, metal foils and external leads into a glass tube thus produced. Then, make a lamp by sealing (pinch sealing) both ends of the glass tube.

Fig. 6 shows a schematic configuration of a heat treatment device in which the filament lamp according to the present invention is used.

Inside a chamber of the treatment device is disposed an object to be treated. Also disposed are filament lamps lamp L11, L12, L13, L14, L15 facing the front/top surface of the object to be treated and filament lamps L21, L22, L23, L24, L25 facing the rear/bottom surface of the object to be treated. The treatment device is connected with a vacuum pump to maintain the space inside the device with a reduced pressure atmosphere. The object to be treated is held by a support.

In the present invention, the term "metal foils corresponding to the number of filaments" does not necessarily refer to the provision of the same number of metal foils as the number of filaments. For example, the filament F1 in Fig.1 may be divided in the longitudinal direction to make multiple filaments.

## Claims

1. A filament lamp (L), comprising:
a straight-tube luminous part (10) having multiple filaments (F1, F2, F3) arranged one after the other in an axial direction of the luminous part (10), and sealing parts (20a, 20b) on each of opposite ends of the luminous part (10) in which metal foils (31 a, 32a, 33a, 31 b, 32b, 33b) corresponding to the number of filaments (F1, F2, F3) are disposed in an aligned manner,
internal leads (51a, 51b, 52a, 52b, 53a, 53b) provided for each of the filaments (F1, F2, F3) in a manner enabling electricity to be independently supplied to each filament (F1, F2, F3),
wherein the luminous part (10) comprises a first housing space (11) for housing the filaments (F1, F2, F3) and a second housing space (12) for housing the internal leads (51 a, 51 b, 52a, 52b, 53a, 53b); and
wherein the housing spaces (11, 12) are connected and extend in the axial direction **characterized in that**
partitions (13a, 13b, 13c) are formed between the first housing space (11) and the second housing space (12).

2. The filament lamp (L) according to Claim 1, wherein the cross section of the luminous part (10) is at least internally substantially gourd-shaped.

3. The filament lamp (L) according to Claim 1 or 2, wherein the filaments (F1, F2, F3) are held in the first housing space (11) by ring-shaped supporters (14a, 14b, 14c).

4. The filament lamp (L) according to Claim 2 or 3, wherein the cross section of the luminous part (10) is substantially gourd-shaped internally and externally.

5. The filament lamp (L) according to Claim 2 or 3, wherein the cross section of the luminous part (10) is substantially gourd-shaped internally and has an oval shape externally.

6. The filament lamp (L) according to any one of Claims 1 to 5, wherein the first and second housing spaces (11, 12) are of the same size.

7. The filament lamp (L) according to any one of Claims 1 to 5, wherein the first and second housing spaces (11, 12) are of different sizes.

8. The filament lamp (L) according to any one of Claims 1 to 7; wherein the partitions (13a, 13b, 13c) are formed as parts of a single flat plate with holes through which the internal leads (51 a, 52a, 51 b, 52b) are routed.

## Patentansprüche

1. Glühlampe (L), umfassend:
einen Leuchtteil in Form eines geraden Rohrs (10) mit mehreren Glühdrähten (F1, F2, F3), die nacheinander in Achsrichtung des Leuchtteils (10) angeordnet sind, Versiegelungsteilen (20a, 20b) an jedem der entgegengesetzten Enden des Leuchtteils (10), in dem Metallfolien (31 a, 32a, 33a, 31 b, 32b, 33b), die der Anzahl der Glühdrähte (F1, F2, F3) entsprechen, in einer aufeinander ausgerichteten Weise angeordnet sind, und inneren Anschlussdrähten (51 a, 51 b, 52a, 52b, 53a, 53b),
die für jeden der Glühdrähte (F1, F2, F3) auf eine Weise vorgesehen sind, die es ermöglicht, dass jeder Glühdraht (F1, F2, F3) unabhängig mit Elektrizität versorgt werden kann,
wobei der Leuchtteil (10) einen ersten Aufnahmeraum (11) zur Aufnahme der Glühdrähte (F1, F2, F3) und einen zweiten Aufnahmeraum (12) zur Aufnahme der inneren Anschlussdrähte (51a, 51 b, 52a, 52b, 53a, 53b) umfasst; und
wobei die Aufnahmeräume (11, 12) miteinander verbunden sind und sich in Achsrichtung erstrecken,
**dadurch gekennzeichnet, dass**
Abtrennungen (13a, 13b, 13c) zwischen dem ersten Aufnahmeraum (11) und dem zweiten Aufnahmeraum (12) gebildet sind.

2. Glühlampe (L) nach Anspruch 1, wobei der Querschnitt des Leuchtteils (10) wenigstens innen im Wesentlichen kürbisförmig ist.

3. Glühlampe (L) nach Anspruch 1 oder 2, wobei die Glühdrähte (F1, F2, F3) in dem ersten Aufnahmeraum (11) durch ringförmige Halterungen (14a, 14b, 14c) gehalten werden.

4. Glühlampe (L) nach Anspruch 2 oder 3, wobei der Querschnitt des Leuchtteils (10) innen und außen im Wesentlichen kürbisförmig ist.

5. Glühlampe (L) nach Anspruch 2 oder 3, wobei der Querschnitt des Leuchtteils (10) innen im Wesentlichen kürbisförmig ist und außen eine ovale Form aufweist.

6. Glühlampe (L) nach einem der Ansprüche 1 bis 5, wobei die ersten und zweiten Aufnahmeräume (11, 12) die gleiche Größe aufweisen.

7. Glühlampe (L) nach einem der Ansprüche 1 bis 5, wobei die ersten und zweiten Aufnahmeräume (11, 12) eine unterschiedliche Größe aufweisen.

8. Glühlampe (L) nach einem der Ansprüche 1 bis 7, wobei die Abtrennungen (13a, 13b, 13c) als Teile aus einer einzelnen ebenen Platte mit Löchern ausgebildet sind, durch die die inneren Anschlussdrähte (51 a, 52a, 51 b, 52b) geführt werden.

## Revendications

1. Une lampe à incandescence (L), comprenant:
une partie lumineuse à tube droit (10) ayant de multiples filaments (F1, F2, F3) disposés les uns après les autres en direction axiale de la partie lumineuse (10), et des éléments d'étanchéité (20a, 20b) sur chacune des extrémités opposées de la partie lumineuse (10) dans lesquels des feuilles de métal (31a, 32a, 33a, 31 b, 32b, 33b) correspondant au nombre de filaments (F1, F2, F3) sont disposées de façon alignée, des fils internes (51a, 51b, 52a, 52b, 53a, 53b) fournis pour chacun des filaments (F1, F2, F3) de façon à ce que l'électricité soit fournie indépendamment à chaque filament (F1, F2, F3), où la partie lumineuse (10) comprend un premier espace de logement (11) pour loger les filaments (F1, F2, F3) et un deuxième espace de logement (12) pour loger les fils internes (51a, 51b, 52a, 52b, 53a, 53b); et
où les espaces de logement (11, 12) sont connectés et s'étendent dans la direction axiale **caractérisé en ce que**
des partitions (13a, 13b, 1 3c) se forment entre le premier espace de logement (11) et le deuxième espace de logement (12).

2. La lampe à incandescence (L) selon la revendication 1, où la section transversale de la partie lumineuse (10) est au moins à l'intérieur principalement en forme de gourde.

3. La lampe à incandescence (L) selon la revendication 1 ou 2, où les filaments (F1, F2, F3) sont tenus dans le premier espace de logement (11) par des supports en forme d'anneau (14a, 14b, 14c).

4. La lampe à incandescence (L) selon la revendication 2 ou 3, où la section transversale de la partie lumineuse (10) est principalement en forme de gourde à l'intérieur et à l'extérieur.

5. La lampe à incandescence (L) selon la revendication 2 ou 3, où la section transversale de la partie lumineuse (10) est principalement en forme de gourde à l'intérieur et possède une forme ovale à l'extérieur.

6. La lampe à incandescence (L) selon l'une des revendications 1 à 5, où le premier et le deuxième espaces de logement (11, 12) sont de la même taille.

7. La lampe à incandescence (L) selon l'une des revendications 1 à 5, où le premier et le deuxième espaces de logement (11, 12) sont de taille différente.

8. La lampe à incandescence (L) selon l'une des revendications 1 à 7, où les partitions (13a, 13b, 13c) sont formées comme des parties d'une seule plaque plate avec des trous au travers desquels les fils internes (51a, 52a, 51b, 52b) sont acheminés.
